(19)

Europäisches Patentamt
European Patent Office
Office européen des brevets

(11) **EP 4 478 152 A1**

(12) **EUROPEAN PATENT APPLICATION**
published in accordance with Art. 153(4) EPC

(43) Date of publication:
**18.12.2024 Bulletin 2024/51**

(21) Application number: **23775256.3**

(22) Date of filing: **21.03.2023**

(51) International Patent Classification (IPC):
**G06F 1/16** (2006.01)          **G09F 9/30** (2006.01)
**G02F 1/1333** (2006.01)      **H10K 77/10** (2023.01)

(52) Cooperative Patent Classification (CPC):
**G02F 1/1333; G06F 1/16; G09F 9/30; H10K 77/10**

(86) International application number:
**PCT/KR2023/003706**

(87) International publication number:
**WO 2023/182760 (28.09.2023 Gazette 2023/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **21.03.2022   KR 20220034655**

(71) Applicant: **Samsung Electronics Co., Ltd
Suwon-si, Gyeonggi-do 16677 (KR)**

(72) Inventors:
• **JUNG, Jihyung
  Suwon-si, Gyeonggi-do 16677 (KR)**
• **AHN, Sungho
  Suwon-si, Gyeonggi-do 16677 (KR)**
• **KANG, Jooyoung
  Suwon-si, Gyeonggi-do 16677 (KR)**

• **KIM, Kwangtai
  Suwon-si, Gyeonggi-do 16677 (KR)**
• **PARK, Sanghyuk
  Suwon-si, Gyeonggi-do 16677 (KR)**
• **YEOM, Donghyun
  Suwon-si, Gyeonggi-do 16677 (KR)**
• **WOO, Sunggwan
  Suwon-si, Gyeonggi-do 16677 (KR)**
• **LEE, Soyoung
  Suwon-si, Gyeonggi-do 16677 (KR)**
• **JI, Youngmin
  Suwon-si, Gyeonggi-do 16677 (KR)**
• **CHOI, Sungdae
  Suwon-si, Gyeonggi-do 16677 (KR)**

(74) Representative: **Appleyard Lees IP LLP
15 Clare Road
Halifax HX1 2HY (GB)**

(54) **ELECTRONIC DEVICE COMPRISING FLEXIBLE DISPLAY**

(57)    An electronic device comprising a flexible display, according to an embodiment of the present disclosure, may comprise: a first housing; a second housing which is slidably coupled to the first housing; and a flexible display the display area of which has an increased or decreased size, wherein: the flexible display comprises a panel layer, a plurality of intermediate layers, a protective layer for protecting the panel layer, a grating layer, and a plurality of adhesive layers; and the protective layer comprises a first region on one surface of which the adhesive layers are laminated and arranged, and a second region which extends from one end of the first region in a direction parallel to the first region and at least a part of which has a smaller thickness than the thickness of the first region.

EP 4 478 152 A1

# FIG. 6A

600

626
625
624
623
622
621

650
634
633
640
632
631

612
L1
L2

610   611   613   L3

z
x   y

621      631
622      632
620      630
623      633
624      634
625
626

## Description

[Technical Field]

The disclosure relates to an electronic device including a flexible display.

[Background Art]

A flexible display (e.g., rollable display) may be composed of a panel for driving a display and upper and lower protective layers for protecting the panel.

A stacked structure of the flexible display may include a polyimide film at an upper portion of the panel, and include a protective layer in an upper portion of the polyimide film. The stacked structure of the flexible display may include an impact absorption layer at a lower portion of the panel and a metal plate for preventing deformation of the display.

The stacked structure of the flexible display may include a pressure sensitive adhesive (PSA) between each stacked layer. The PSA may bond each layer and slide to correspond to the change in length occurred when the flexible display sliding moves.

[Disclosure of Invention]

[Technical Problem]

In the case that a flexible display in the prior art is bent, a portion of the flexible display may interfere with a slide cover that protects a display module due to a swelling phenomenon caused by a repulsion force of the display module (e.g., a phenomenon that a central part of the display module in which a holding force of a guide rail is weakened is lifted by a repulsion force). Further, a swelling phenomenon may occur, and a portion of the PSA included in a flexible display structure may slip and be positioned in the slide cover.

In the case that a portion of the PSA is positioned in the slide cover, a problem may occur that an aesthetic impression of an appearance of the electronic device including the flexible display is deteriorated. Further, in the case that a portion of the PSA is adhered to the slide cover, a problem may occur in which a driving force required to sliding move the flexible display increases.

An electronic device including a flexible display according to an embodiment of the disclosure may provide a constitution that can prevent problems of an appearance and increased display driving force.

[Solution to Problem]

According to an embodiment of the disclosure, an electronic device including a flexible display may include a first housing; a second housing slidably coupled to the first housing; and a flexible display in which a size of a display area, which is an externally visible part of the electronic device is reduced or expanded based on slide-in or slide-out driving of the second housing, wherein the flexible display may include a panel layer including a display panel; a protective layer disposed in one direction of the panel layer and configured to protect the panel layer; a lattice layer disposed in another direction of the panel layer; a plurality of intermediate layers disposed between the protective layer and the panel layer and including at least one impact absorption layer; and a plurality of adhesive layers each disposed between each layer included in the flexible display, wherein the protective layer may include a first area in which the adhesive layers are stacked on one surface; and a second area extended from one end of the first area in a direction parallel to the first area and in which a thickness of at least a portion thereof is smaller than that of the first area.

According to an embodiment of the disclosure, an electronic device including a flexible display may include a first housing; a second housing slidably coupled to the first housing; and a flexible display in which a size of a display area, which is an externally visible part of the electronic device is reduced or expanded based on slide-in or slide-out driving of the second housing, wherein the flexible display may include a panel layer including a display panel; a protective layer disposed in one direction of the panel layer and configured to protect the display panel; a lattice layer disposed in another direction of the panel layer; a plurality of intermediate layers including at least one impact absorption layer; and a plurality of adhesive layers each disposed between each layer included in the flexible display, wherein the protective layer may include a first area in which the adhesive layers are stacked on one surface; and a second area extended from one end of the first area, bent and extended toward a height direction of the flexible display in at least a portion, and connected to the lattice layer.

[Advantageous Effects of Invention]

According to an embodiment of the disclosure, an electronic device including a flexible display includes a protective layer of an extended form to prevent a pressure sensitive adhesive from directly contacting a slide cover, thereby preventing problems of an appearance of the electronic device and an increased display driving force.

[Brief Description of Drawings]

FIG. 1 is a block diagram illustrating an electronic device in a network environment according to an embodiment.
FIGS. 2A and 2B are diagrams illustrating a front surface and rear surface of an electronic device in a slide-in state according to an embodiment of the disclosure.

FIGS. 3A and 3B are diagrams illustrating a front surface and rear surface of an electronic device in a slide-out state according to an embodiment of the disclosure.

FIG. 4 is an exploded perspective view illustrating an electronic device according to an embodiment of the disclosure.

FIG. 5A is a cross-sectional view illustrating an electronic device taken along line 5a-5a of FIG. 2A according to an embodiment of the disclosure.

FIG. 5B is a cross-sectional view illustrating an electronic device taken along line 5b-5b of FIG. 3A according to an embodiment of the disclosure.

FIGS. 6A, 6B, and 6C are diagrams illustrating a flexible display including an extended protective layer according to an embodiment of the disclosure.

FIG. 7 is a conceptual diagram illustrating the difference in length of each layer of a flexible display according to an embodiment of the disclosure.

FIGS. 8A and 8B are diagrams illustrating a flexible display including a coating layer according to an embodiment of the disclosure.

FIGS. 9A and 9B are diagrams illustrating a flexible display including a concave area according to an embodiment of the disclosure.

FIGS. 10A and 10B are diagrams illustrating a flexible display including a first area and a second area extended obliquely according to an embodiment of the disclosure.

FIGS. 11A and 11B are diagrams illustrating a flexible display including a first area and a second area obliquely extended in a slide-out state and a slide-in state according to an embodiment of the disclosure.

FIGS. 12A and 12B are diagrams illustrating a flexible display including a protective layer connected to a lattice layer according to an embodiment of the disclosure.

FIGS. 13A and 13B are diagrams illustrating a flexible display including a protective layer connected to a lattice layer in a slide-out state and a slide-in state according to an embodiment of the disclosure.

[Mode for the Invention]

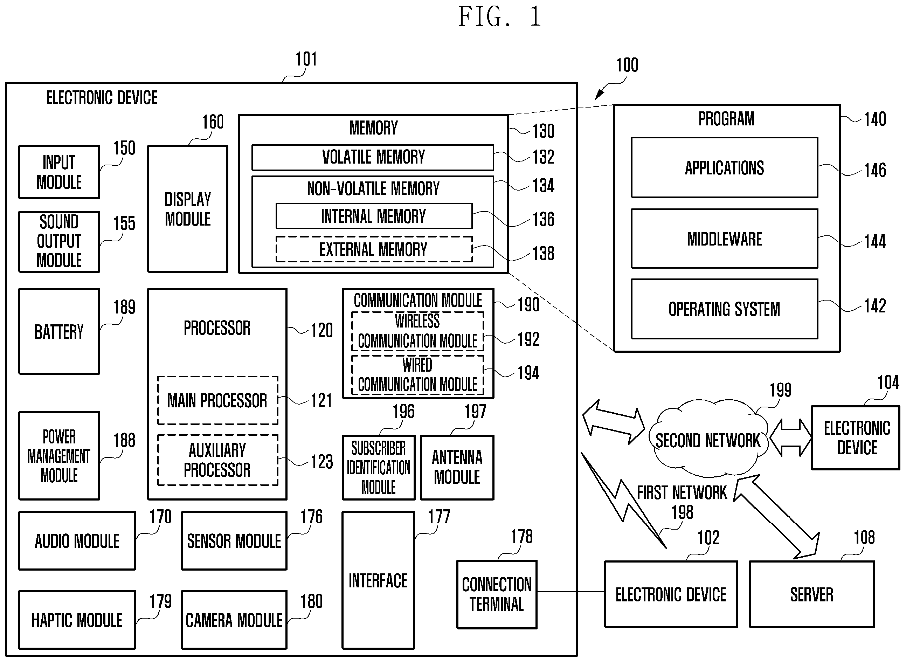

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

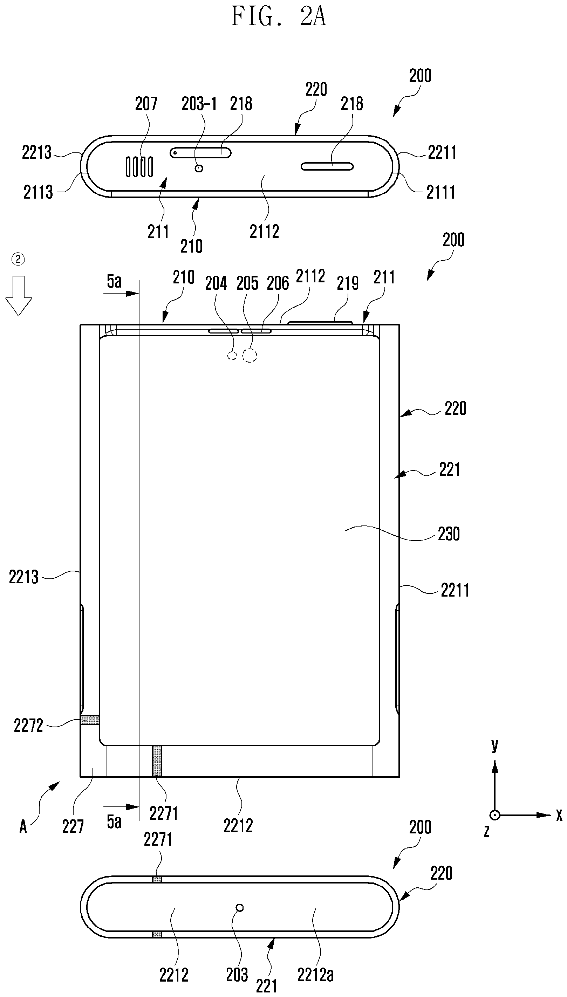

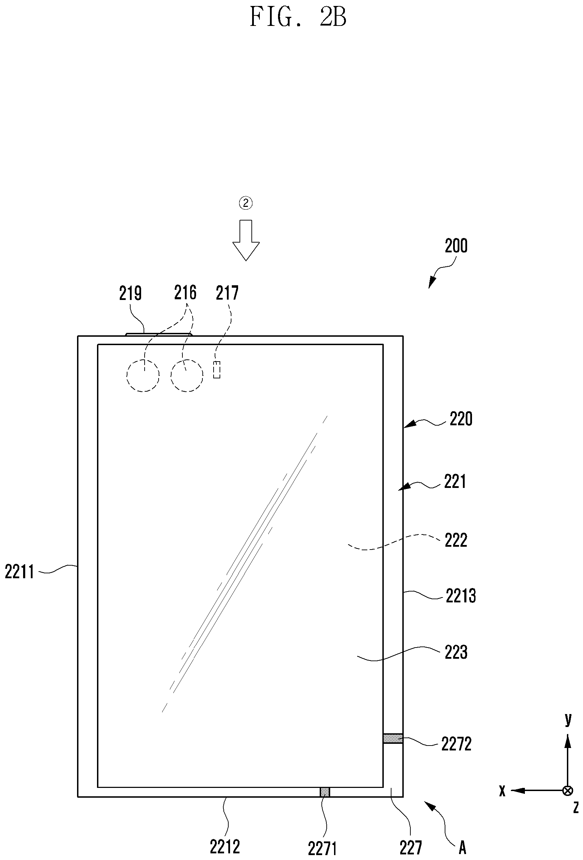

FIGS. 2A and 2B are diagrams illustrating a front surface and rear surface of an electronic device in a slide-in state according to an embodiment of the disclosure.

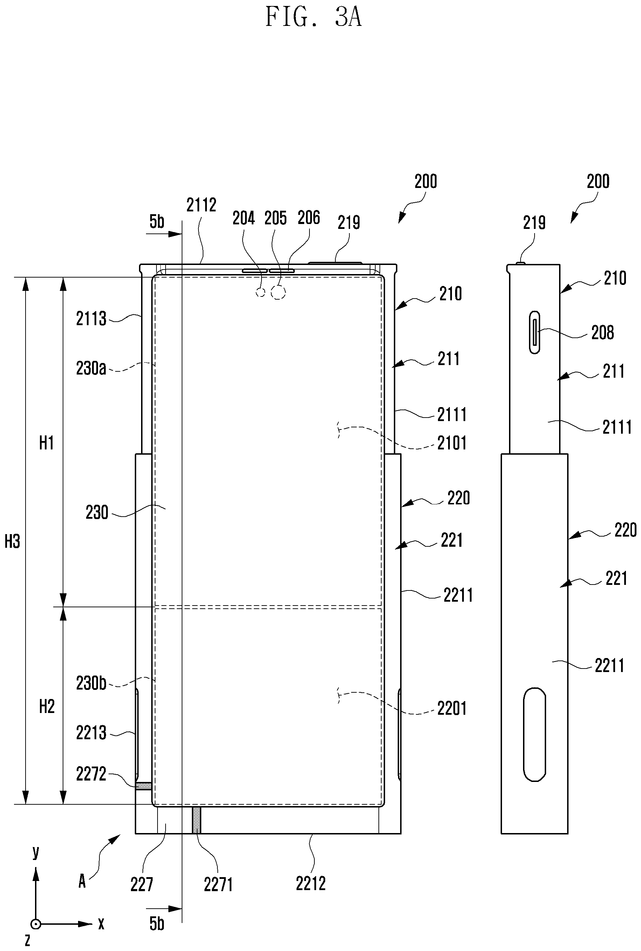

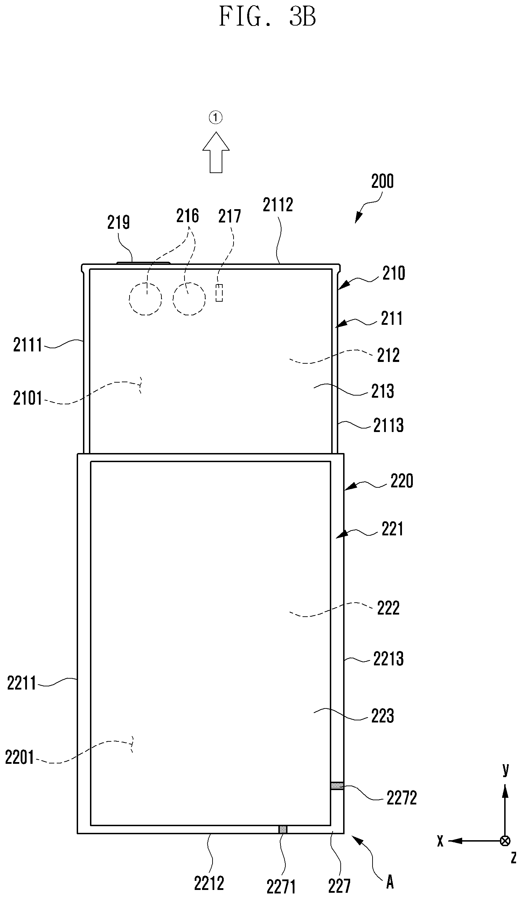

FIGS. 3A and 3B are diagrams illustrating a front surface and rear surface of an electronic device in a slide-out state according to an embodiment of the disclosure.

An electronic device 200 of FIGS. 2A to 3B may be at least partially similar to the electronic device 101 of FIG. 1 or may further include other components of the electronic device.

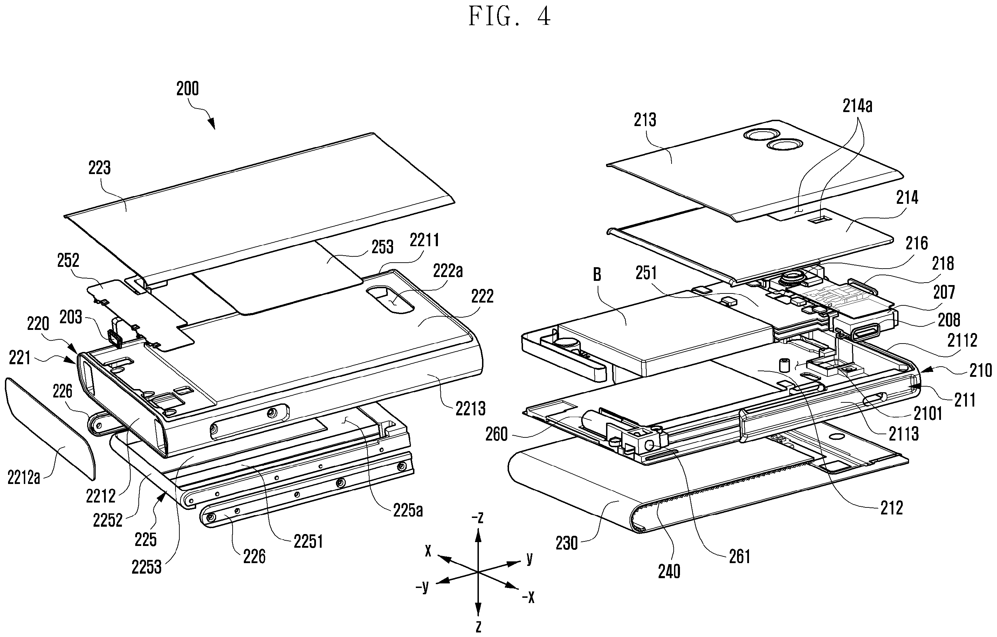

With reference to FIGS. 2A to 3B, the electronic device 200 may include a first housing 220 (e.g., first housing structure, fixing part, or base housing), a second housing 210 (e.g., second housing structure, moving part, or slide housing) slidably coupled to the first housing 220 in a designated direction (e.g., direction ① or direction (2) (e.g., ±y-axis direction)), and a flexible display 230 (e.g., expandable display or stretchable display) disposed to be supported by at least a portion of the first housing 220 and the second housing 210. According to an embodiment, the electronic device 200 may be disposed so that the second housing 210 slides out in a first direction (direction ①) and slides in in a second direction (direction (2)), which is a direction opposite to the first direction (direction ①) based on the first housing 220 held by the user. According to an embodiment, as at least a portion of the second housing 210 including the first space 2101 is received in the second space 2201 of the first housing 220, a state of the electronic device 200 may be changed to a slide-in state. According to an embodiment, the electronic device 200 may include a bendable member or bendable support member (e.g., a bendable member 240 of FIG. 4) (e.g., multi-joint hinge module or multibar assembly) for forming at least partially the same plane as that of at least a portion of the second housing 210 in a slide-out state and at least partially received in the second space 2201 of the first housing 220 in a slide-in state. According to an embodiment, at least a portion of the flexible display 230 may be received in an internal space 2201 of the first housing 220 while being supported by the bendable member (e.g., a bendable member 240 of FIG. 4) to be disposed invisibly from the outside in the slide-in state. According to an embodiment, at least a portion of the flexible display 230 may be disposed visibly from the outside while being supported by the bendable member (e.g., the bendable member 240 of FIG. 4) that forms at least partially the same plane as that of the second housing 210 in the slide-out state.

According to an embodiment, the electronic device 200 may include a second housing 210 including a first lateral member 211 and a first housing 220 including a second lateral member 221. According to an embodiment, the first lateral member 211 may include a first side surface 2111 having a first length along a first direction (e.g., y-axis direction), a second side surface 2112 extended to have a second length shorter than the first length along a direction (e.g., x-axis direction) substantially perpendicular to the first side surface 2111, and a third side surface 2113 extended substantially parallel to the first side surface 2111 from the second side surface 2112 and having a first length. According to an embodiment, the first lateral member 211 may be at least partially made of a conductive material (e.g., metal). In some embodiments, the first lateral member 211 may be formed by combining a conductive material and a non-conductive material (e.g., polymer). According to an embodiment, the second housing 210 may include a first support member 212 extended from at least a portion of the first lateral member 211 to at least a portion of the first space 2101. According to an embodiment, the first support member 212 may be formed integrally with the first lateral member 211. In some embodiments, the first support member 212 may be constituted separately from the first lateral member 211 and be structurally coupled to the first lateral member 211.

According to an embodiment, the second lateral member 221 may include a fourth side surface 2211 at least partially corresponding to the first side surface 2111 and having a third length, a fifth side surface 2212 extended from the fourth side surface 2211 in a direction substantially parallel to the second side surface 2211 and having a fourth length shorter than the third length, and a sixth side surface 2213 extended from the fifth side surface 2212 to correspond to the third side surface 2113 and having a third length. According to an embodiment, the second lateral member 221 may be at least partially made of a conductive material (e.g., metal). In some embodiments, the second lateral member 221 may be formed by combining a conductive material and a non-conductive material (e.g., polymer). According to an embodiment, at least a portion of the second lateral member 221 may include a second support member 222 extended to at least a portion of the second space 2201 of the first housing 220. According to an embodiment, the second support member 222 may be formed integrally with the second lateral member 221. In some embodiments, the second support member 222 may be constituted separately from the second lateral member 221 and be structurally coupled to the second lateral member 221.

According to an embodiment, the first side surface 2111 and the fourth side surface 2211 may be slidably coupled to each other. According to an embodiment, the third side surface 2113 and the sixth side surface 2213 may be slidably coupled to each other. According to an embodiment, in the slide-in state, the first side surface 2111 may overlap the fourth side surface 2211 to be disposed to be substantially invisible from the outside. According to an embodiment, in the slide-in state, the third side surface 2113 may overlap the sixth side surface 2213 to be disposed to be substantially invisible from the outside. In some embodiments, at least a portion of the first side surface 2111 and the third side surface 2113 may be disposed to be at least partially visible from the outside in the slide-in state. According to an embodiment, in the slide-in state, the first support member 212 may overlap the second support member 222 to be disposed to be substantially invisible from the outside. In some embodiments, in the slide-in state, a portion of the first support member 212 may overlap the second support member 222 to be disposed to be invisible from the outside, and the remaining portions of the first support member 212 may be disposed to be visible from the outside.

According to an embodiment, the electronic device 200 may include a first rear cover 213 coupled to the second housing 210 at the rear surface. According to an embodiment, the first rear cover 213 may be disposed through at least a portion of the first support member 212. In some embodiments, the first rear cover 213 may be formed integrally with the first lateral member 211. According to an embodiment, the first rear cover 213 may be made of polymer, coated or colored glass, ceramic, metal (e.g., aluminum, stainless steel (STS), or magnesium), or a combination of at least two of these materials. In some embodiments, the first rear cover 213 may be extended to at least a portion of the first lateral member 211. In some embodiments, at least a portion of the first support member 212 may be replaced with the first rear cover 213.

According to an embodiment, the electronic device 200 may include a second rear cover 223 coupled to the first housing 220 at the rear surface. According to an embodiment, the second rear cover 223 may be disposed through at least a portion of the second support member 222. In some embodiments, the second rear cover 223 may be formed integrally with the second lateral member 221. According to an embodiment, the second rear cover 223 may be made of polymer, coated or colored glass, ceramic, metal (e.g., aluminum, stainless steel (STS), or magnesium), or a combination of at least two of these materials. In some embodiments, the second rear cover 223 may be extended to at least a portion of the second lateral member 221. In some embodiments, at least a portion of the second support member 222 may be replaced with the second rear cover 223.

According to an embodiment, the electronic device 200 may include a flexible display 230 disposed to be supported by at least a portion of the first housing 220 and the second housing 210. According to an embodiment, the flexible display 230 may include a first portion 230a (e.g., flat portion) always visible from the outside and a second portion 230b (e.g., bendable portion) extended from the first portion 230a and at least partially received in the second space 2201 of the first housing 220 so that at least a portion thereof is not visible from the outside in the slide-in state. According to an embodiment, the first portion 230a may be disposed to be supported by the second housing 210, and the second portion 230b may be disposed to be at least partially supported by a bendable member (e.g., a bendable member 240 of FIG. 4). According to an embodiment, the second portion 230b of the flexible display 230 may be extended from the first portion 230a while being supported by the bendable member (e.g., the bendable member 240 of FIG. 4) in a state in which the second housing 210 is slid out along the first direction (direction ①), form substantially the same plane as that of the first portion 230a, and be disposed to be visible from the outside. According to an embodiment, the second portion 230b of the flexible display 230 may be received in the second space 2201 of the first housing 220 in a state in which the second housing 210 is slid in along the second direction (direction (2)) and be disposed to be invisible from the outside. Accordingly, the electronic device 200 may guide to change a display area of the flexible display 230 as the second housing 210 is moved in a sliding manner along a designated direction (e.g., ±y-axis direction) from the first housing 220.

According to an embodiment, the length of the flexible display 230 in the first direction (direction ①) may vary according to a sliding movement of the second housing 210 moved based on the first housing 220. For example, the flexible display 230 may have a first display area (e.g., an area corresponding to the first portion 230a) corresponding to a first display length H1 in the slide-in state. According to an embodiment, in the slide-out state, the flexible display 230 may be expanded to have a third display area (e.g., an area including the first portion 230a and the second portion 230b) corresponding to a third display length H3 longer than the first display length H1 and larger than the first display area according to a sliding movement of the second housing 210 additionally moved by a second display length H2 based on the first housing 220.

According to an embodiment, the electronic device 200 may include at least one of an input device (e.g., microphone 203-1), a sound output device (e.g., call receiver 206 or speaker 207), sensor modules 204 and 217, a camera module (e.g., first camera module 205 or second camera module 216), a connector port 208, a key input device 219, or an indicator (not illustrated) disposed in the first space 2101 of the second housing 210. According to an embodiment, the electronic device 200 may include another input device (e.g., microphone 203) disposed in the second housing. In another embodiment, the electronic device 200 may be constituted so that at least one of the above-described components is omitted or other components are additionally included. In another embodiment, at least one of the above-described components may be disposed in the second space 2201 of the first housing 220.

According to an embodiment, the input device may include a microphone 203-1. In some embodiments, the input device (e.g., the microphone 203-1) may include a plurality of microphones disposed to detect a direction of sound. The sound output device may include, for example, a call receiver 206 and a speaker 207. According to an embodiment, the speaker 207 may correspond to the outside through at least one speaker hole formed in the second housing 210 at a position always exposed to the outside (e.g., the second side surface 2112) regardless of the slide-in/ slide-out state. According to an embodiment, the connector port 208 may correspond to the outside through a connector port hole formed in the second housing 210 in the slide-out state. In some embodiments, the connector port 208 may correspond to the outside through an opening formed in the second housing and formed to correspond to a connector port hole in the slide-in state. In some embodiments, the call receiver 206 may include a speaker (e.g., piezo speaker) operating without a separate speaker hole.

According to an embodiment, the sensor modules 204 and 217 may generate electrical signals or data values corresponding to an internal operation state or an external environment state of the electronic device 200. The sensor modules 204 and 217 may include, for example, a first sensor module 204 (e.g., proximity sensor or illuminance sensor) disposed at the front surface of the electronic device 200 and/or a second sensor module 217 (e.g., heart rate monitoring (HRM) sensor) disposed at the rear surface of the electronic device 200. According to an embodiment, the first sensor module 204 may be disposed under the flexible display 230 at the front surface of the electronic device 200. According to an embodiment, the first sensor module 204 and/or the second sensor module 217 may include at least one of a proximity sensor, an illumination sensor, a time of flight (TOF) sensor, an ultrasonic sensor, a fingerprint recognition sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, or a humidity sensor.

According to an embodiment, the camera module may include a first camera module 205 disposed at the front surface of the electronic device 200 and a second camera module 216 disposed at the rear surface of the electronic device 200. According to an embodiment, the electronic device 200 may include a flash (not illustrated) positioned near the second camera module 216. According to an embodiment, the camera modules 205 and 216 may include one or more lenses, an image sensor, and/or an image signal processor. According to an embodiment, the first camera module 205 may be disposed under the flexible display 230 and be configured to photograph a subject through a portion of an active area (e.g., display area) of the flexible display 230.

According to an embodiment, the first camera module 205 among the camera modules and some sensor module 204 among the sensor modules 204 and 217 may be disposed to detect an external environment through the flexible display 230. For example, the first camera module 205 or some sensor module 204 may be disposed to contact the external environment in the first space 2201 of the second housing 210 through a transmission area or a perforated opening formed in the flexible display 230. According to an embodiment, an area facing the first camera module 205 of the flexible display 230 is a portion of the display area that displays contents and may be formed as a transmission area with a designated transmittance. According to an embodiment, the transmission area may have a transmittance of a range of about 5% to about 20%. Such a transmission area may include an area overlapped with an effective area (e.g., field of view area) of the first camera module 205 through which light for generating an image by an image sensor is transmitted. For example, the transmission area of the flexible display 230 may include an area in which a pixel disposition density and/or a wiring density are/is lower than that of a periphery area. For example, the transmission area may replace the above-described opening. For example, some camera modules 205 may include an under display camera (UDC). In some embodiments, some sensor module 204 may be disposed to perform a function thereof without being visually exposed through the flexible display 230 in an internal space of the electronic device 200.

According to an embodiment, the electronic device 200 may include at least one antenna electrically connected to a wireless communication circuit (e.g., the wireless communication module 192 of FIG. 1) disposed in the second housing 210. According to an embodiment, the electronic device 200 may include a bezel antenna A disposed through the conductive second lateral member 221 of the second housing 210. For example, the bezel antenna A may include a conductive portion 227 disposed in at least a portion of the fifth side surface 2212 and the sixth side surface 2213 of the second lateral member 221 and electrically divided through at least one segment portions 2271 and 2272 made of a non-conductive material (e.g., polymer). According to an embodiment, a wireless communication circuit (e.g., the wireless communication module 192 of FIG. 1) may be configured to transmit or receive a wireless signal in at least one frequency band (e.g., about 800 MHz to 6000 MHz) (e.g., legacy band) designated through the conductive portion 227. According to an embodiment, the electronic device 200 may include a side cover 2212a disposed at the fifth side surface 2212 so as to cover at least a portion of the at least one segment portion 2271. In some embodiments, the bezel antenna A may be disposed in at least one of the second side surface 2112, the fourth side surface 2211, the fifth side surface 2212, or the sixth side surface 2213. In some embodiments, the electronic device 200 may further include at least one antenna module (e.g., 5G antenna module or antenna structure) disposed in an internal space (e.g., the first space 2101 or the second space 2201) and disposed to transmit or receive a wireless signal in a frequency band range of about 3 GHz to 100 GHz through another wireless communication circuit (e.g., the wireless communication module 192 of FIG. 1).

According to an embodiment, a slide-in/slide-out operation of the electronic device 200 may be performed automatically. For example, the slide-in/slide-out operation of the electronic device 200 may be performed through a gearing operation of a drive motor (e.g., a drive motor 260 of FIG. 4) including a pinion gear disposed in the first space 2101 of the second housing 210 and a rack gear (e.g., a rack gear 2251 of FIG. 4) disposed in the second space 2201 of the first housing 220 and meshed with the pinion gear 261. For example, in the case that the processor (e.g., the processor 120 of FIG. 1) of the electronic device 200 detects a triggering operation for changing from the slide-in state to the slide-out state or from the slide-out state to the slide-in state, the processor may operate the drive motor (e.g., the drive motor 260 of FIG. 4) disposed within the electronic device 200. According to an embodiment, the triggering operation may include an operation of selecting (e.g., touching) an object displayed on the flexible display 230 or manipulating a physical button (e.g., key button) included in the electronic device 200.

The electronic device 200 according to exemplary embodiments of the disclosure has a design structure (e.g., a structure in which the drive motor 260 is disposed at the lower end of the second housing 210 in the slide-in state) in which a drive motor (e.g., a drive motor 260 of FIG. 4) is disposed in an end portion (e.g., a lower end of the second housing 210 in a slide-in state) in the slide-in direction (direction (2)) in the first space 2101 of the second housing 210 and in which a pinion gear of the drive motor 260 moves on a rack gear (e.g., the rack gear 2251 of FIG. 4) disposed to correspond to the second space 2201 of the first housing 220, thereby providing an extended sliding stroke. Further, the electronic device 200 includes electronic components (e.g., substrate or battery) disposed together with the drive motor 260 in the first space 2101 of the second housing 210, thereby providing an efficient electrical connection structure with the drive motor 260. Further, the electronic device 200 includes a support structure disposed in the second space 2201 of the first housing 220 so as to support at least a portion of the flexible display 230 in the slide-out state, thereby helping improve operational reliability thereof.

Hereinafter, a detailed description of the electronic device will be described below.

FIG. 4 is an exploded perspective view illustrating an electronic device according to an embodiment of the disclosure.

In describing the electronic device 200 of FIG. 4, the same reference numerals are given to substantially the same components as those of the electronic device 200 of FIGS. 2A to 3B, and detailed descriptions thereof may be omitted.

With reference to FIG. 4, the electronic device 200 may include a second housing 210 including a first space 2101, a first housing 220 slidably coupled to the second housing 210 and including a second space (e.g., the second housing 2201 of FIG. 3A), a bendable member 240 at least partially rotatably disposed in the second space 2201, a flexible display 230 disposed to be supported by at least a portion of the bendable member 240 and the second housing 220, and a drive module for driving the second housing 210 in a slide-in direction (e.g., -y-axis direction) and/or a slide-out direction (e.g., y-axis direction) from the first housing 220. According to an embodiment, the drive module may include a drive motor 260 disposed in the first space 2101 and including a pinion gear and a rack gear 2251 disposed to mesh with the pinion gear 261 in the second space 2201. According to an embodiment, the drive module may further include a deceleration module disposed to reduce the rotational speed and increase the driving force by being coupled to the drive motor 260. According to an embodiment, the drive motor 260 may be disposed to be supported through at least a portion of the first support member 212 in the first space 2101 of the second housing 210. According to an embodiment, the drive motor 260 may be fixed to an end portion (e.g., edge) of the first support member 212 in the slide-in direction (e.g., -y-axis direction) in the first space 2101.

According to an embodiment, the electronic device 200 may include a plurality of electronic components disposed in the first space 2101. According to an embodiment, a plurality of electronic components may include a first substrate 251 (e.g., main board), a camera module 216, a socket module 218 (e.g., SIM tray), a speaker 207, a connector port 208, and a battery B disposed around the first substrate 251. According to an embodiment, because a plurality of electronic components are disposed around the first substrate 251 in the first space 2101 of the second housing 210 together with the drive motor 260, efficient electrical connection thereof may be possible.

According to an embodiment, the electronic device 200 may include a rear bracket 214 disposed to cover at least some of a plurality of electronic components between the first support member 212 and the first rear cover 213 of the second housing 210. According to an embodiment, the rear bracket 214 may be structurally coupled to at least a portion of the first support member 212. In some embodiments, the rear bracket 214 may be omitted. According to an embodiment, the rear bracket 214 may be disposed to cover a plurality of electronic components and to support the first rear cover 213. According to an embodiment, the rear bracket 214 may include a notch area 214a or an opening 214a (e.g., through hole) formed in an area corresponding to the camera module 216 and/or the sensor module (e.g., the sensor module 217 of FIG. 3B). According to an embodiment, the camera module 216 and/or the sensor module 217 may be disposed to detect an external environment through the notch area 214a or the opening 214a. According to an embodiment, an area of the first rear cover 213 corresponding to at least the camera module 216 and/or the sensor module 217 may be processed to be transparent. In some embodiments, the camera module 216 and/or the sensor module 217 may be configured to operate only in the case that the electronic device 200 is in a slide-out state.

According to an embodiment, the electronic device 200 may include a plate type support bracket 225 (e.g., display support bar (DSB)) disposed in the second space 2201 of the first housing 220 and slidably coupled to at least a portion of the first support member 212. According to an embodiment, the support bracket 225 may include an opening 225a of a designated size. According to an embodiment, the support bracket 225 may include a support part 2252 disposed at one end and having a curved outer surface so as to support a rear surface of the bendable member 240 bent during a sliding operation. According to an embodiment, the support bracket 225 may include a support plate 2253 extended from at least a portion of the support part 2252 to at least a portion of the opening 225a to be formed to support the rear surface of the bendable member 240 in the slide-out state. According to an embodiment, the support bracket 225 may include a rack gear 2251 fixed to cross the opening 225a and to have a length along a direction parallel to the sliding direction. In some embodiments, the rack gear 2251 may be formed integrally with the support bracket 225. According to an embodiment, the electronic device 200 may include a pair of guide rails 226 disposed at both side surfaces of the support bracket 225 to guide both ends of the bendable member 240 in the sliding direction.

According to an embodiment, when the electronic device 200 is in the slide-in state, the first housing 220 may include an opening 222a (e.g., through hole) disposed in an area corresponding to the camera module 216 and/or the sensor module 217 disposed in the second housing 210 in the second support member 222. According to an embodiment, when the electronic device 200 is in the slide-in state, the camera module 216 and/or the sensor module 217 may detect an external environment through the opening 222a formed in the first housing 220. In this case, an area of the second rear cover 223 corresponding to at least the camera module 216 and/or the sensor module 217 may be processed to be transparent.

According to an embodiment, the electronic device 200 may include a second substrate 252 and an antenna member 253 disposed in a space between the second support member 222 and the second rear cover 223 of the first housing 220. According to an embodiment, the second substrate 252 and the antenna member 253 may be electrically connected to the first substrate 251 through at least one electrical connection member (e.g., flexible printed circuit board (FPCB) or flexible RF cable (FRC)). In some embodiments, the antenna member 253 may be electrically connected to the second substrate 252, thereby being electrically connected to the first substrate 251 through the second substrate 252.

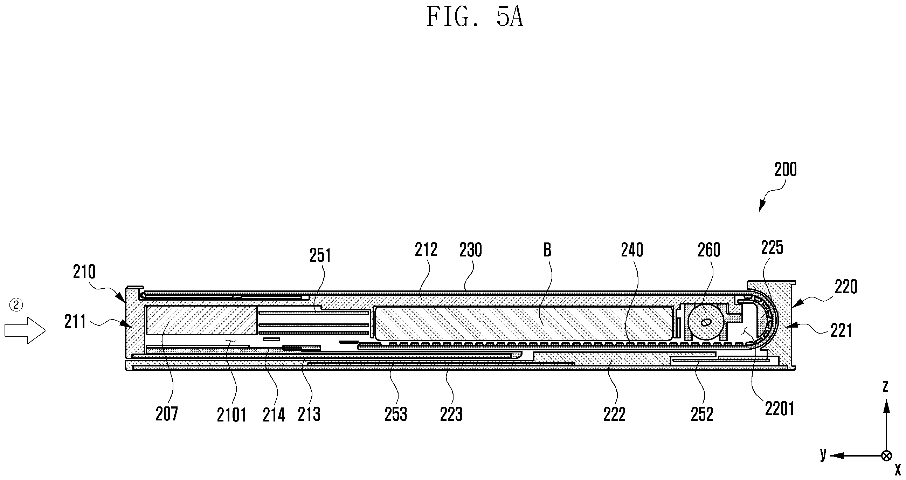

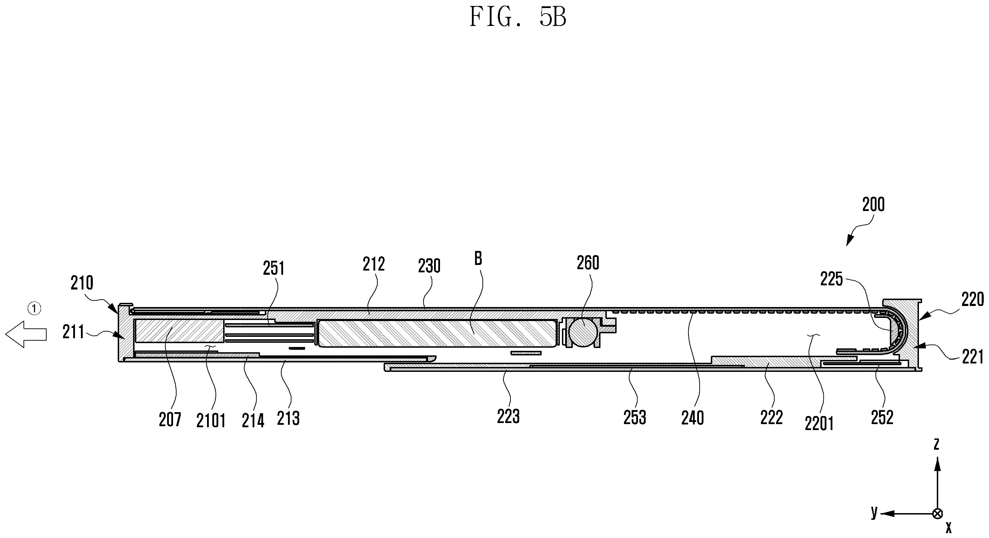

FIG. 5A is a cross-sectional view illustrating an electronic device taken along line 5a-5a of FIG. 2A according to an embodiment of the disclosure. FIG. 5B is a cross-sectional view illustrating an electronic device taken along line 5b-5b of FIG. 3A according to an embodiment of the disclosure.

In describing the electronic device of FIGS. 5A and 5B, the same reference numerals are given to substantially the same components as those of the electronic device of FIG. 4, and detailed descriptions thereof may be omitted.

With reference to FIGS. 5A and 5B, the electronic device 200 may include a second housing 210 having a first space 2101, a first housing 220 having a second space 2201, a bendable member 240 connected to the second housing 210 and at least partially received in the second space 2201 in the slide-in state, a flexible display 230 disposed to be supported by at least a portion of the bendable member 240 and at least a portion of the second housing 210, and a drive motor 260 disposed in the first space 2101 and including a pinion gear meshed with a rack gear of the second space 2201. According to an embodiment, the drive motor 260 may automatically move the second housing 210 in the slide-in direction (direction (2)) or the slide-out direction (direction ①) based on the first housing 220.

According to an embodiment, in the slide-in state of the electronic device 200, at least a portion of the second housing 210 may be received in the second space 2201 of the first housing 220. According to an embodiment, the first support member 212 may be slidably coupled and be guided by the support bracket 225 disposed in the second space 2201. In this case, as at least a portion of the flexible display 230 is received in the second space 2201 together with the bendable member 240, it may be disposed to be invisible from the outside. Accordingly, a first display area of the flexible display 230 may be exposed to the outside.

According to an embodiment, at least a portion of the second housing 210 may be changed to the slide-out state at least partially exposed to the outside of the first housing 220 along the first direction (direction ①) through driving of the drive motor 260. According to an embodiment, in the slide-out state of the electronic device 200, as the flexible display 230 is supported by the support bracket 225 and is moved together with the bendable member 240, a portion slid in at the second space 2201 may be at least partially exposed to the outside. Accordingly, in the flexible display 230, an expanded second display area larger than the first display area may be exposed to the outside.

According to an embodiment, as the drive motor 260 and electronic components (e.g., the first substrate 251 and the battery B) disposed in the second housing 210 move together according to the slide-in/slide-out operation of the second housing 210, the corresponding components may be disposed in the first housing 220, and electrical connection members are minimized compared to a disposition structure connected to the first substrate 251 through the electrical connection members, thereby helping operational reliability improvement of the electronic device 200 and efficient disposition design of electronic components.

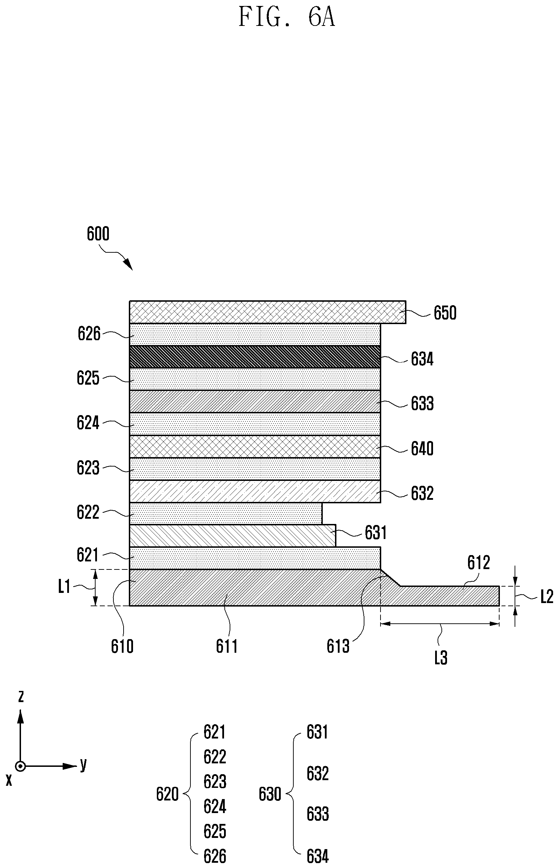

FIG. 6A is a diagram illustrating a flexible display 600 including an extended protective layer 610 in a first state according to an embodiment of the disclosure.

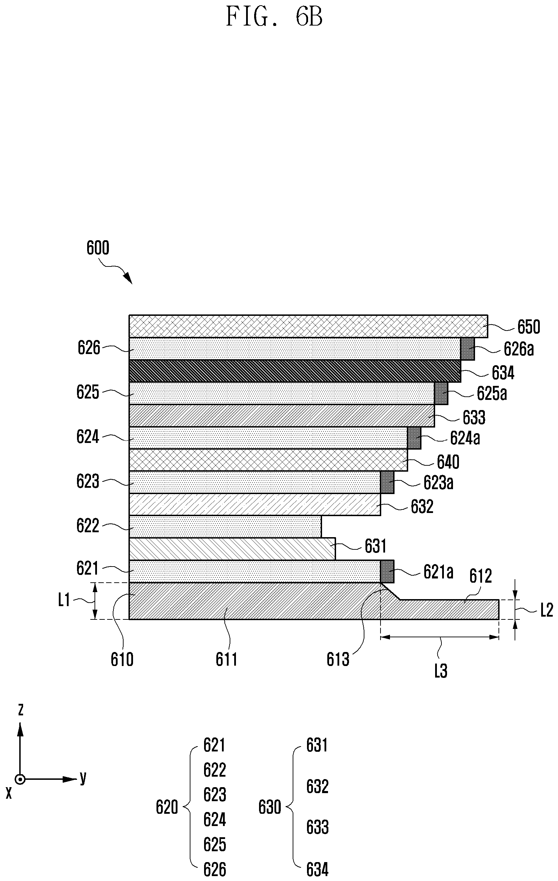

FIG. 6B is a diagram illustrating a flexible display 600 including an extended protective layer 610 in a second state according to an embodiment of the disclosure.

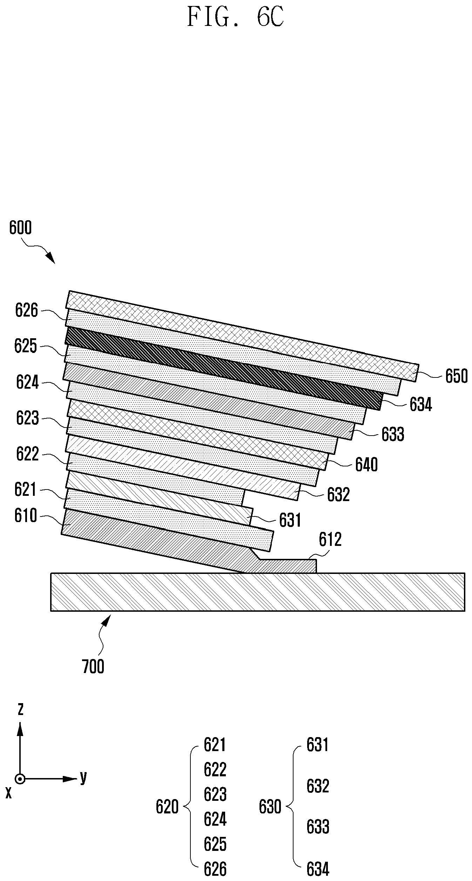

FIG. 6C is a diagram illustrating a flexible display and a slide cover including an extended protective layer according to an embodiment of the disclosure.

The flexible display 600 illustrated in FIGS. 6A, 6B, and 6C may mean the flexible display 230 illustrated in FIGS. 5A and 5B.

In describing the flexible display 600 according to an embodiment of the disclosure, a height direction of the flexible display 600 may mean the z-axis direction, and a length direction of the flexible display 600 may mean the y-axis direction. A width direction of the flexible display 600 may mean the x-axis direction.

In an embodiment, a first state may mean a state in which the flexible display 600 does not sliding move and in which each layer of the flexible display 600 is aligned and disposed. A second state may mean a state in which while the electronic device 200 (see FIGS. 5A and 5B) is converted to a slide-in state or a slide-out state, the flexible display 600 sliding moves and slip thus occurs in at least a portion of an adhesive layer 620 included in the flexible display 600. FIG. 6A illustrates the flexible display 600 in a first state, and FIG. 6B illustrates the flexible display 600 in a second state.

In an embodiment, the flexible display 600 may include a protective layer 610, an adhesive layer 620, an intermediate layer 630, a panel layer 640, and/or a lattice layer 650.

With reference to FIGS. 6A and 6B, the protective layer 610 may be disposed at one side surface of the flexible display 600, and the lattice layer 650 may be disposed at the other surface of the flexible display 600, which is an opposite surface of the protective layer 610 in the flexible display 600.

In an embodiment, the flexible display 600 may include a plurality of adhesive layers 620. With reference to FIGS. 6A and 6B, the adhesive layer 620 may include a first adhesive layer 621, a second adhesive layer 622, a third adhesive layer 623, a fourth adhesive layer 624, a fifth adhesive layer 625 and/or a sixth adhesive layer 626.

In an embodiment, the adhesive layer 620 may include a pressure sensitive adhesive (PSA). The PSA may be adhered to a surface of an object even with a low pressure. The PSA may not solidify but have a semi-fluid property. Because the adhesive layer 620 includes a PSA, the flexible display 600 may move and the adhesive layer 620 may slip.

In an embodiment, the adhesive layer 620 may be disposed between each layer of the flexible display 600. For example, the first adhesive layer 621 may be disposed between the protective layer 610 and the first intermediate layer 631. The second adhesive layer 622 may be disposed between the first intermediate layer 631 and the second intermediate layer 632.

In an embodiment, the flexible display 600 may include a plurality of intermediate layers 630. For example, the intermediate layer 630 may include a first intermediate layer 631, a second intermediate layer 632, a third intermediate layer 633, and/or a fourth intermediate layer 634.

In an embodiment, the first intermediate layer 631 may include glass. Glass may serve to protect the panel layer 640. The second intermediate layer 632 may include a polyimide (PI) film. The third intermediate layer 633 may include polyethylene terephthalate (PET). The fourth intermediate layer 634 may include an impact absorbing material. The fourth intermediate layer 634 may be an impact absorption layer that prevents an impact transferred from the lattice layer 650 to the panel layer 640.

In an embodiment, the panel layer 640 may include a display panel.

In an embodiment, the lattice layer 650 may include a metal material or a plastic material. The lattice layer 650 may include a plurality of openings (not illustrated). A plurality of openings (not illustrated) included in the lattice layer 650 may be disposed at intervals in a length direction and width direction of the flexible display 600. In the case that the lattice layer 650 includes a plurality of openings (not illustrated), the flexible display 600 may be easily bent.

In an embodiment, a bendable member 240 (see FIG. 4) may be disposed in at least a portion of the lattice layer 650.

In an embodiment, the protective layer 610, the first adhesive layer 621, the first intermediate layer 631, the second adhesive layer 622, the second intermediate layer 632, the third adhesive layer 623, the panel layer 640, the fourth adhesive layer 624, the third intermediate layer 633, the fifth adhesive layer 625, the fourth intermediate layer 634, the sixth adhesive layer 626, and the lattice layer 650 may be disposed in that order based on the height direction (e.g., z-axis direction) of the flexible display 600.

In an embodiment, the protective layer 610 may serve to protect the panel layer 640 and the intermediate layer 630.

In an embodiment, the protective layer 610 may include a first area 611 and a second area 612. The first area 611 of the protective layer 610 may be an area in which the first adhesive layer 621 is disposed at one surface (e.g., a surface facing the positive z-axis). A length of the first area 610 may be the same as that of the first adhesive layer 621 based on the length direction (e.g., y-axis direction) of the flexible display 600.

In an embodiment, the second area 612 of the protective layer 610 may be extended in a length direction (e.g., y-axis direction) of the flexible display 600, which is a direction parallel to a direction in which the first area 611 is extended at one end of the first area 611.

In an embodiment, a height direction of the second area 612 may mean the z-axis direction, and a length direction of the second area 612 may mean the y-axis direction.

In an embodiment, a thickness of at least a portion of the second area 612 of the protective layer 610 may be smaller than that of the first area 611.

In an embodiment, the overall thickness of the second area 612 of the protective layer 610 may be smaller than the thickness of the first area 611. For example, the thickness of the first area 611 may be formed in a first length L1, and the thickness of the second area 612 may be formed in a second length L2. The second length L2 may be smaller than the first length L1.

In an embodiment, the second length L2 of the protective layer 610 is smaller than the first length L 1; thus, the adhesive layer 620 may not contact the second area 612 of the protective layer 610.

In an embodiment, the second area 612 may include an inclined area 613 in at least a portion thereof. The inclined area 613 may mean an area extended obliquely rather than parallel to the first area 611 in an area of the second area 612 connected to the first area 611. Because the thickness of the second area 612 is smaller than that of the first area 611, the second area 612 may be extended with a reduced thickness in the inclined area 613.

In an embodiment, the second area 612 may be extended by a third length L3 in the length direction of the second area 612. The third length L3 may be longer than the sum of sliding lengths of the plurality of adhesive layers 620.

With reference to FIG. 6B, in the case that the electronic device 200 (see FIG. 5B) is switched between the slide-out state and the slide-in state and that the flexible display 600 sliding moves, slip may occur in each of the first adhesive layer 621, the third adhesive layer 623, the fourth adhesive layer 624, the fifth adhesive layer 625, and the sixth adhesive layer 626.

In an embodiment, an area in which slip occurs in each adhesive layer 620 may be defined as a slip area (e.g., 621a). For example, an area in which slip occurs in the first adhesive layer 621 may be defined as a first slip area 621a. An area in which slip occurs in the third adhesive layer 623 may be defined as a third slip area 623a. An area in which slip occurs in the fourth adhesive layer 624 may be defined as a fourth slip area 624a. An area in which slip occurs in the fifth adhesive layer 625 may be defined as a fifth slip area 625a. An area in which slip occurs in the sixth adhesive layer 626 may be defined as a sixth slip area 626a. The second adhesive layer 622 may be an adhesive layer 620 in which slip does not occur.

In an embodiment, a length (e.g., a third length L3) in which the second area 612 is extended may be longer than the sum of lengths (e.g., lengths in the y-axis direction) of each area of the adhesive layer 620 in which slip occurs, except for the adhesive layer (e.g., 622) in which slip does not occur. For example, with reference to FIG. 6B, the third length L3 of the second area 612 may be longer than the sum of lengths (e.g., lengths in the y-axis direction) of the first slip area 621a, the third slip area 623 a, the fourth slip area 624a, the fifth slip area 625a, and the sixth slip area 626a.

A slide cover 700 may be positioned to be spaced apart from the flexible display 600 in the z-axis direction. In the case that the flexible display 600 sliding moves, the flexible display 600 may be disposed at an angle based on the slide cover 700. In the case that the flexible display 600 is disposed at an angle and that a portion of the adhesive layer 620 slides and comes into direct contact with the slide cover 700, the adhesive layer 620 is adhered to the slide cover 700; thus, the flexible display 600 may become difficult to operate.

With reference to FIG. 6C, the flexible display 600 according to an embodiment of the disclosure includes a protective layer 610 extended in the length direction to prevent the adhesive layer 620 from directly contacting the slide cover 700. For example, in the case that the flexible display 600 is disposed at an angle, the adhesive layer 620 may not directly contact the slide cover 700, but the second area 612 of the protective layer 610 may contact the slide cover 700. While the second area 612 contacts the slide cover 700, a portion of the adhesive layer 620 may be prevented from directly contacting the slide cover 700.

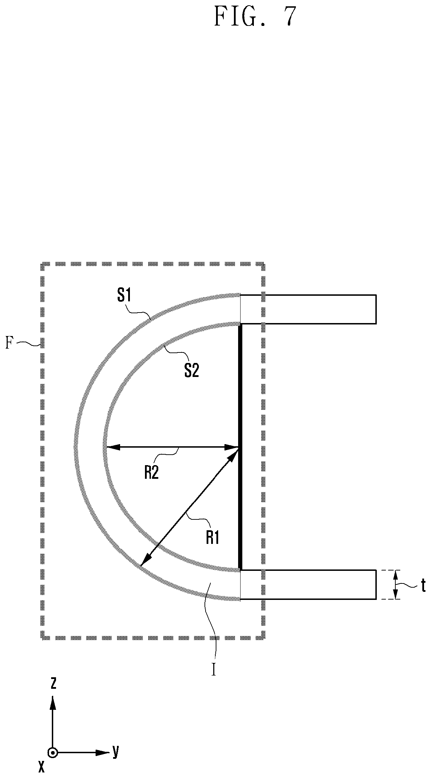

FIG. 7 is a conceptual diagram illustrating the difference in length of each layer of a flexible display 600 according to an embodiment of the disclosure.

With reference to FIG. 7, the flexible display 600 may include a bending area F in which at least a portion thereof is bent in a semicircular shape. In the bending area F, an inner layer I included in the flexible display 600 may be bent with a predetermined radius of curvature. The inner layer I may mean an intermediate layer 630 or a panel layer 640 illustrated in FIG. 6A.

In an embodiment, an adhesive layer 620 may be disposed at one surface and the other surface of the inner layer I. For example, with reference to FIG. 6A, in the case that the inner layer I is the panel layer 640, a third adhesive layer 623 may be disposed at one surface of the panel layer 640, and a fourth adhesive layer 624 may be disposed at the other surface of the panel layer 640.

In an embodiment, the adhesive layer 620 disposed at one surface of the inner layer I may have a first circumferential length S 1 and be extended in the bending area F. The first circumferential length S 1 may mean a half of a circumferential length of a circle having a first radius R1.

In an embodiment, the adhesive layer 620 disposed at the other surface of the inner layer I may have a second circumferential length S2 and be extended in the bending area F. The second circumferential length S2 may mean a half of a circumferential length of a circle having a second radius R2. Because the first radius R1 is longer than the second radius R2, the first circumferential length S 1 may be longer than the second circumferential length S2.

In an embodiment, the adhesive layer 620 disposed at one surface of the inner layer I may slip by the difference between the first circumferential length S 1 and the second circumferential length S2. For example, the difference between the first circumferential length S 1 and the second circumferential length S2 may be the maximum value of a sliding length of the adhesive layer 620 disposed at one surface of the inner layer I.

In an embodiment, the difference between the first circumferential length S 1 and the second circumferential length S2 may be proportional to a thickness t of the inner layer I. The first circumferential length S 1 may have a relationship of Equation 1 with the first radius R1, and the first circumferential length S2 may have a relationship of Equation 2 with the second radius R2. With reference to Equation 3, the first radius R1 and the second radius R2 may differ by the thickness t of the inner layer I. Equation 4 may be derived using Equation 1, Equation 2, and Equation 3. With reference to Equation 4, the difference between the first circumferential length S 1 and the second circumferential length S2 may be proportional to the thickness t of the inner layer I. Because the difference between the first circumferential length S 1 and the second circumferential length S2 may be the maximum value of the sliding length of the adhesive layer 620 disposed at one surface of the inner layer I, the maximum value of the length in which the adhesive layer 620 slides may be proportional to the thickness t of the inner layer I in which the adhesive layer 620 is disposed.

[Equation 1]

$$S1 = R1 \times \pi$$

[Equation 2]

$$S2 = R2 \times \pi$$

[Equation 3]

$$R2 = R1 - t$$

[Equation 4]

$$S1 - S2 = t \times \pi$$

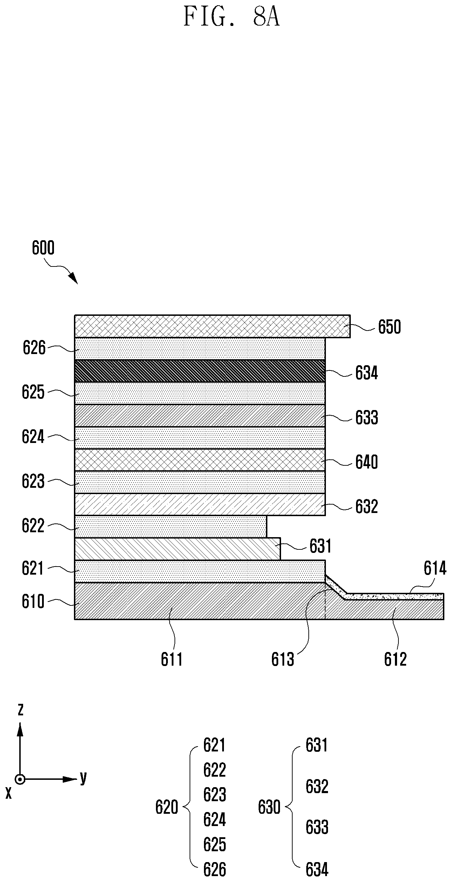

FIG. 8A is a diagram illustrating a flexible display 600 including a coating layer 614 in a first state according to an embodiment of the disclosure.

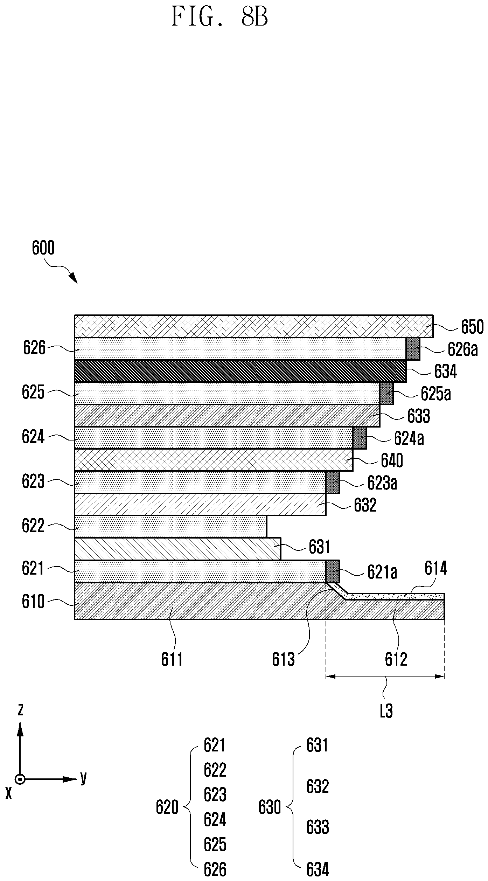

FIG. 8B is a diagram illustrating a flexible display 600 including a coating layer 614 in a second state according to an embodiment of the disclosure.

In an embodiment, a coating layer 614 may be disposed at one surface of a second area 612 of a protective layer 610. For example, the coating layer 614 may be disposed in the positive z-axis direction based on the second area 612. The coating layer 614 may also be disposed at one surface of an inclined area 613 of the second area 612. The coating layer 614 may be formed in a predetermined thickness in a height direction (e.g., z-axis direction) of the flexible display 600.

The coating layer 614 may include a material having weak adhesion to the adhesive layer 620. For example, the coating layer 614 may include release paper made of silicone. Even if a portion of the adhesive layer 620 contacts the coating layer 614, the adhesive layer 620 and the coating layer 614 may not be adhered. In the case that the flexible display 600 sliding moves, the adhesive layer 620 is not adhered to the coating layer 614; thus, a problem of an increased driving force required to move the flexible display 600 by the adhesive layer 620 may be reduced.

In an embodiment, the coating layer 614 may be extended by a third length L3 based on the length direction (e.g., y-axis direction) of the flexible display 600. The third length L3 may be longer than the sum of sliding lengths of the plurality of adhesive layers 620. For example, with reference to FIG. 8B, the third length L3 of the coating layer 614 may be longer than the sum of lengths (e.g., lengths in the y-axis direction) of a first slip area 621a, a third slip area 623 a, a fourth slip area 624a, a fifth slip area 625a, and a sixth slip area 626a. In the case that slip occurs in the adhesive layer 620, the third length L3 of the coating layer 614 is longer than a sliding length of the adhesive layer 620; thus, a slip area (e.g., 621a) of the adhesive layer 620 may be disposed in the coating layer 614.

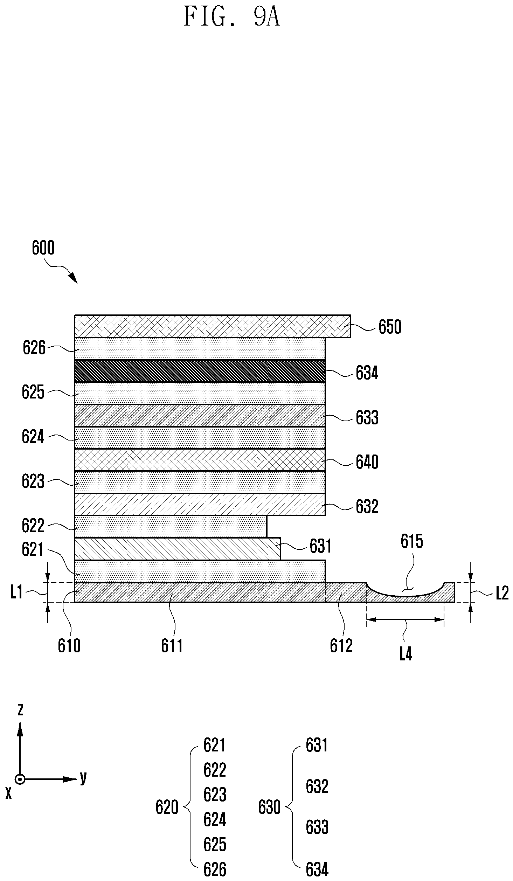

FIG. 9A is a diagram illustrating a flexible display 600 including a concave area 615 in a first state according to an embodiment of the disclosure.

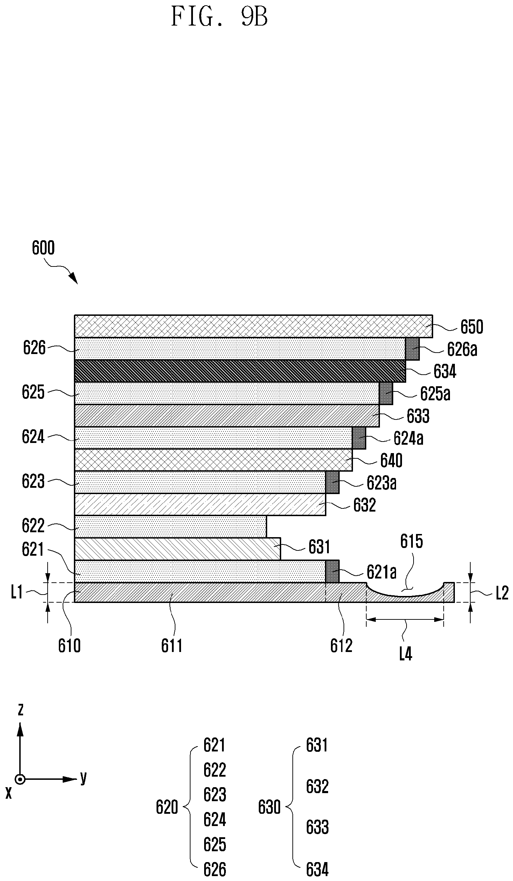

FIG. 9B is a diagram illustrating a flexible display 600 including a concave area 615 in a second state according to an embodiment of the disclosure.

In an embodiment, a height direction of the second area 612 may mean the z-axis direction, and a length direction of the second area 612 may mean the y-axis direction.

In an embodiment, the second area 612 of the protective layer 610 may include a concave area 615 in at least a portion thereof. The concave area 615 may be an area in which at least a portion of the second area 612 is concavely formed in a height direction of the second area 612. For example, in the concave area 615, at least a portion of the second area 612 may have a concave shape in the negative z-axis direction.

In an embodiment, a thickness of the second area 612 may be at least partially smaller than that of the first area 611. For example, with reference to FIG. 9A, the thickness of the second area 612 in the concave area 615 may be smaller than the first length L1, which is the thickness of the first area 611. A portion of the second area 612 excluding the concave area 615 may have a thickness equal to the second length L2. The second length L2 may be equal to or smaller than the first length L1.

Due to a repeated slide movement of the flexible display 600, an area in which slip has occurred among the plurality of adhesive layers 620 is concentrated in the protective layer 610 to cause a problem in which a driving force for moving the flexible display 600 increases. The flexible display 600 according to an embodiment of the disclosure may include a concave area 615 to prevent an area in which slip has occurred in the adhesive layer 620 from being concentrated and clumped together in a portion of the protective layer 610. Among the plurality of adhesive layers 620, an area in which slip has occurred may be disposed in the concave area 615 to prevent the area in which slip has occurred from being concentrated and clumped together in a portion of the protective layer 610. For example, a first slip area 621a, a third slip area 623a, a fourth slip area 624a, a fifth slip area 625a, and/or a sixth slip area 621a generated when the adhesive layer 620 slides may be disposed in the concave area 615.

In an embodiment, the concave area 615 may be extended in a width direction (e.g., x-axis direction) of the flexible display 600.

In an embodiment, the concave area 615 may have a width equal to the fourth length L4 based on a length direction (e.g., y-axis direction) of the flexible display 600. The fourth length L4 may vary according to the number of adhesive layers 620 included in the flexible display 600.

In an embodiment, the fourth length L4 may be equal to or longer than a length in which one of the plurality of adhesive layers 620 slides. For example, with reference to FIG. 9B, the fourth length L4 may be equal to or longer than a length (e.g., the length in the y-axis direction) of the first slip area 621a.

In an embodiment, the plurality of adhesive layers 620 may be equal to or longer than the sum of sliding lengths. For example, with reference to FIG. 9B, the fourth length L4 may be equal to or longer than the sum of lengths (e.g., lengths in the y-axis direction) of the first slip area 621a, the third slip area 623a, the fourth slip area 624a, the fifth slip area 625a, and the six slip area 626a.

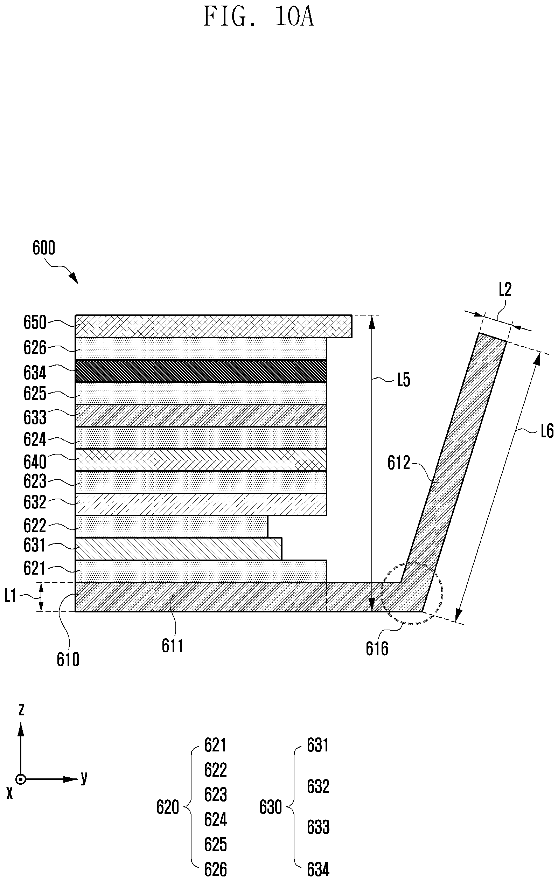

FIG. 10A is a diagram illustrating a flexible display 600 including a first area 611 and a second area 612 extended obliquely in a first state according to an embodiment of the disclosure.

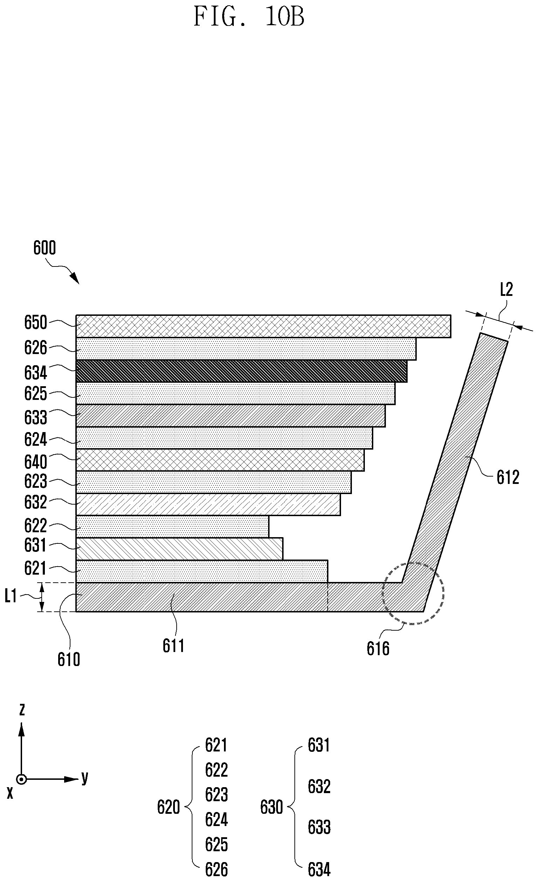

FIG. 10B is a diagram illustrating a flexible display 600 including a first area 611 and a second area 612 extended obliquely in a second state according to an embodiment of the disclosure.

In an embodiment, the second area 612 of a protective layer 610 may be extended from the first area 611 in an inclined direction. For example, the first area 611 may be extended in a length direction (e.g., y-axis direction) of the flexible display 600, and the second area 612 may be extended by a sixth length L6 from the length direction (e.g., y-axis direction) of the flexible display 600 in an inclined direction toward a height direction (e.g., z-axis direction) of the flexible display 600.

In an embodiment, the second area 612 may include a first bending area 616. The second area 612 may be bent and extended from the length direction (e.g., y-axis direction) of the flexible display 600 toward the height direction (e.g., z-axis direction) in the first bending area 616.

In an embodiment, a press device (not illustrated) may be used for bending the second area 612 of the protective layer 610 in the first bend area 616.

In an embodiment, a height (e.g., length in the z-axis direction) of the flexible display 600 may be formed in a fifth length L5.

FIGS. 10A and 10B illustrate that a length of the second area 612 based on the height direction (e.g., z-axis direction) of the flexible display 600 is shorter than the fifth length L5, but the length of the second area 612 may not be limited thereto. For example, the length of the second area 612 based on the height direction (e.g., z-axis direction) of the flexible display 600 may be the same as the fifth length L5. In the case that the length of the second area 612 based on the height direction (e.g., z-axis direction) of the flexible display 600 is the same as the fifth length L5, a sixth length L6, which is an extended length of the second area 612 may be longer than the fifth length L5, which is a length in the height direction of the flexible display 600.

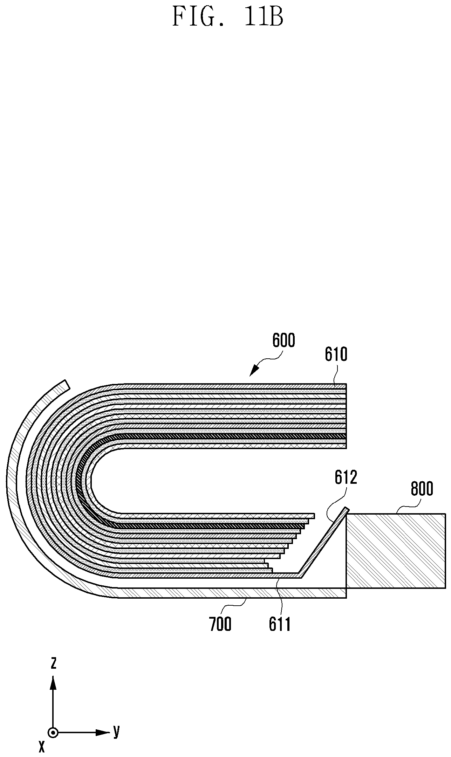

In an embodiment, at least a portion of the second area 612 may be positioned to be spaced apart from a plurality of layers (e.g., layers other than the protective layer 610) included in the flexible display 600 in the length direction (e.g., y-axis direction) of the flexible display 600. With reference to FIG. 10B, in the second state, because at least a portion of the second area 612 is positioned to be spaced apart in a length direction from a plurality of layers (e.g., layers other than the protective layer 610) included in the flexible display 600, the adhesive layer 620 in which slip occurs may be prevented from contacting an external object (e.g., a device object 800 (see FIG. 11B)).

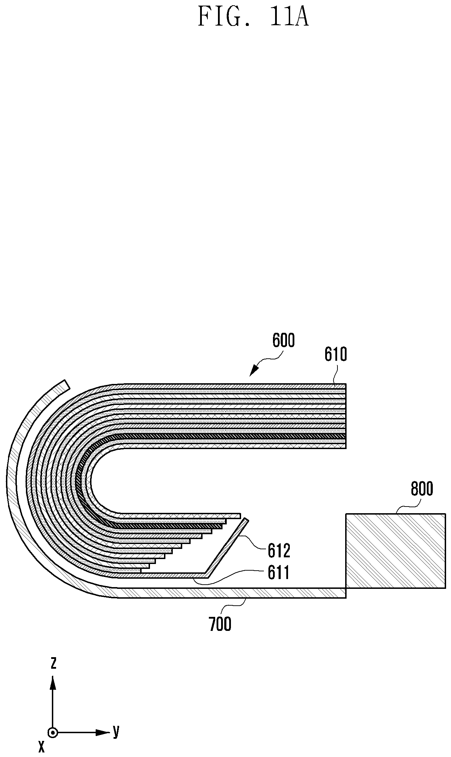

FIG. 11A is a diagram illustrating a flexible display 600 including a first area 611 and a second area 612 extended obliquely in a slide-out state according to an embodiment of the disclosure.

FIG. 11B is a diagram illustrating a flexible display 600 including a first area 611 and a second area 612 extended obliquely in a slide-in state according to an embodiment of the disclosure.

With reference to FIGS. 11A and 11B, a slide cover 700 may be disposed to be spaced apart from at least a portion of the flexible display 600. For example, the slide cover 700 may be disposed to be spaced apart from the protective layer 610 of the flexible display 600. At least a portion of the slide cover 700 may be bent and extended. The slide cover 700 may be positioned to be spaced apart from the flexible display 600 at a portion where the flexible display 600 is bent and extended in a semicircular shape.

In an embodiment, the slide cover 700 may include a second lateral member 221 (see FIG. 5A) and a second support member 222 (see FIG. 5A). For example, the slide cover 700 may be a second support member 222 (see FIG. 5A) formed integrally with the second lateral member 221 (see FIG. 5A).

In an embodiment, a device object 800 may be disposed at a position moved in a length direction (e.g., y-axis direction) based on the second area 612 of the protective layer 610. The device object 800 may mean a component disposed at one side of the flexible display 600. For example, the device object 800 may include a drive motor 260 (see FIG. 5A) disposed at one side of the flexible display 600.

With reference to FIGS. 11A and 11B, while the electronic device 200 (see FIG. 5A) is switched from the slide-out state to the slide-in state, a distance (e.g., distance in the y-axis direction) between the flexible display 600 and the device object 800 may become closer. While the electronic device 200 (see FIG. 5A) is switched from the slide-out state to the slide-in state, at least a portion of the adhesive layer 620 included in the flexible display 600 may slip in a length direction (e.g., y-axis direction) of the flexible display 600. Because the second area 612 of the protective layer 610 is positioned between a plurality of layers (e.g., layers other than the protective layer 610) included in the flexible display 600 and the device object 800, a portion of the adhesive layer 620 may be prevented from directly contacting the device object 800.

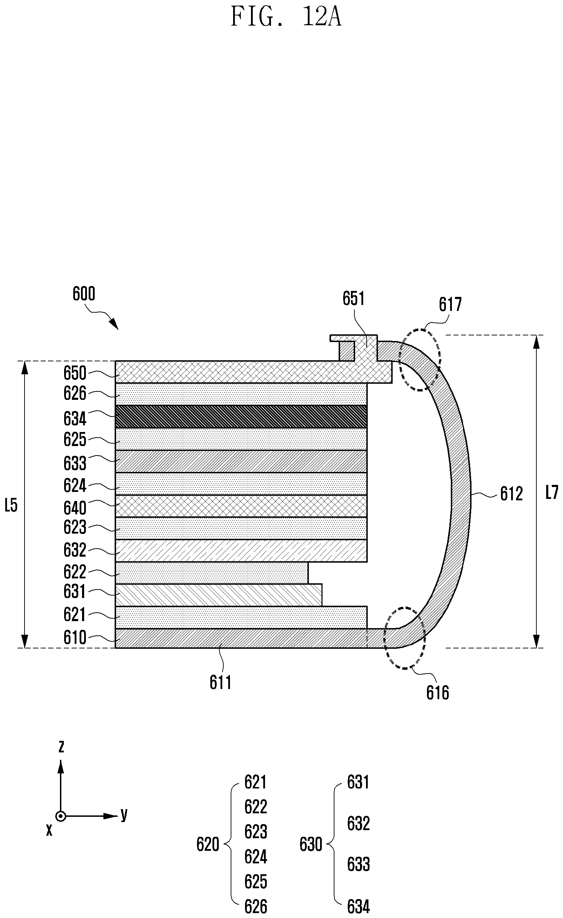

FIG. 12A is a diagram illustrating a flexible display 600 including a protective layer 610 connected to a lattice layer 650 in a first state according to an embodiment of the disclosure.

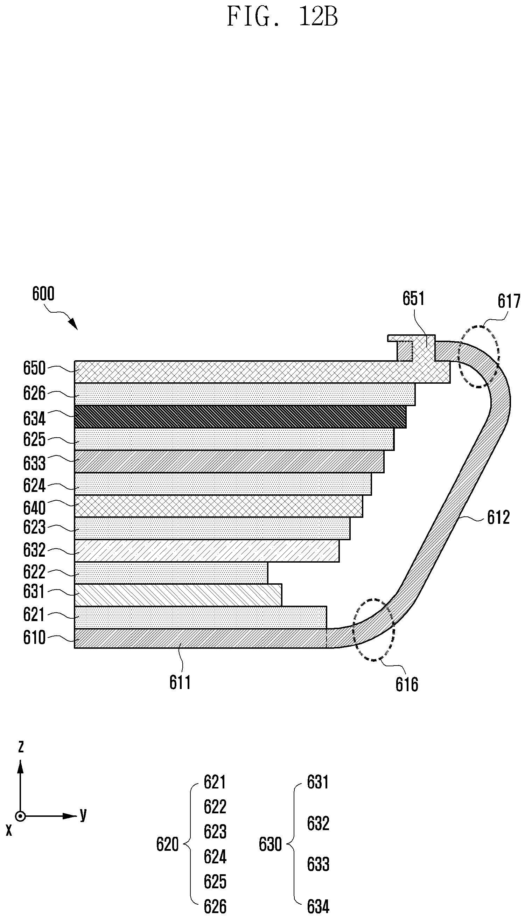

FIG. 12B is a diagram illustrating a flexible display 600 including a protective layer 610 connected to a lattice layer 650 in a second state according to an embodiment of the disclosure.

In an embodiment, the lattice layer 650 may be connected to the protective layer 610 in at least a portion thereof. The lattice layer 650 may include a connection area 651 in at least a portion thereof. The connection area 651 may be formed in a shape protruded from one surface (e.g., a surface facing the positive z-axis direction) of the lattice layer 650. The connection area 651 may be an area connected to the protective layer 610. The protective layer 610 may be coupled to the lattice layer 650 in the connection area 651 using a fitting coupling method or a separate adhesive.

With reference to FIGS. 12A and 12B, the second area 612 of the protective layer 610 may include a first bending area 616 and a second bending area 617.

In an embodiment, the second area 612 may be extended in a length direction (e.g., positive y-axis direction) of the flexible display 600 and be bent and extended in a height direction (e.g., positive z-axis direction) of the flexible display 600 in the first bending area 616.

In an embodiment, the second area 612 may be bent and extended in a direction opposite to that of the first bending area 616 in the second bending area 617. For example, the second area 612 may be extended in a length direction (e.g., positive y-axis direction) of the flexible display 600 and be bent and extended in a direction (e.g., negative z-axis direction) opposite to that bent in the first bend area 616 in the second bend area 617.

In an embodiment, the second area 612 may have a length equal to a seventh length L7 in a height direction (e.g., z-axis direction) of the flexible display 600. The seventh length L7 may be longer than the fifth length L5, which is a thickness of the flexible display 600.

In an embodiment, the second area 612 may be connected to the connection area 651 of the lattice layer 650 at one end thereof. The second area 612 may be coupled to the lattice layer 650 in the connection area 651 using a fitting coupling method or a separate adhesive.

In an embodiment, the second area 612 may be positioned to be spaced apart from a plurality of layers (e.g., layers other than the protective layer 610) included in the flexible display 600 in a length direction (e.g., y-axis direction) of the flexible display 600. With reference to FIG. 12B, even in the case that a portion of the adhesive layer 620 slips, the second area 612 may be positioned to be spaced apart from a plurality of layers (e.g., layers other than the protective layer 610) included in the flexible display 600 in a length direction (e.g., y-axis direction) of the flexible display 600.

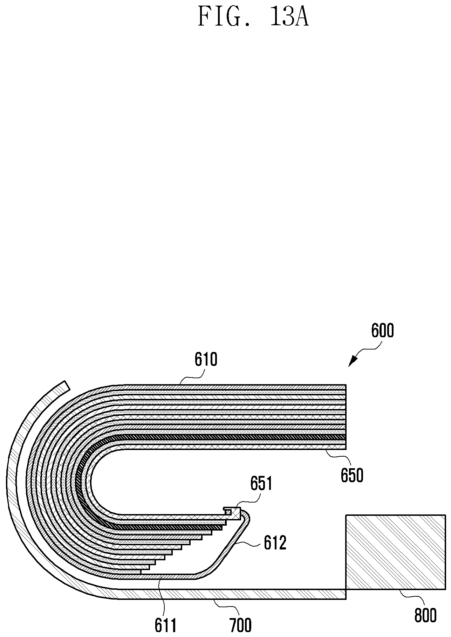

FIG. 13A is a diagram illustrating a flexible display 600 including a protective layer 610 connected to a lattice layer 650 in a slide-out state according to an embodiment of the disclosure.

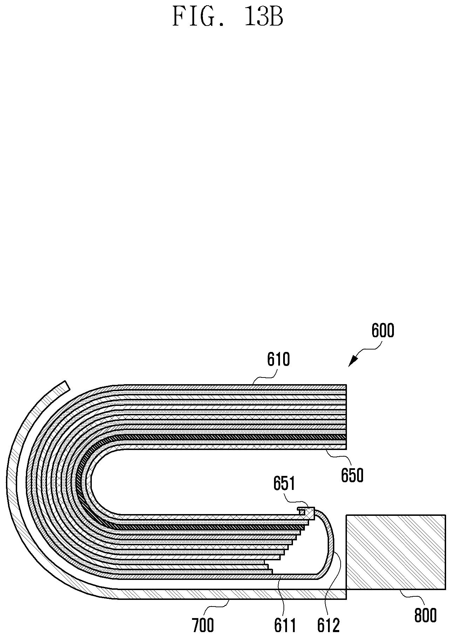

FIG. 13B is a diagram illustrating a flexible display 600 including a protective layer 610 connected to a lattice layer 650 in a slide-in state according to an embodiment of the disclosure.

With reference to FIGS. 13A and 13B, a slide cover 700 may be disposed to be spaced apart from at least a portion of the flexible display 600. For example, the slide cover 700 may be disposed to be spaced apart from the protective layer 610 of the flexible display 600. At least a portion of the slide cover 700 may be bent and extended. The slide cover 700 may be positioned to be spaced apart from the flexible display 600 at a portion where the flexible display 600 is bent and extended in a semicircular shape.

In an embodiment, the slide cover 700 may include a second lateral member 221 (see FIG. 5A) and a second support member 222 (see FIG. 5A). For example, the slide cover 700 may be a second support member 222 (see FIG. 5A) formed integrally with the second lateral member 221 (see FIG. 5A).

In an embodiment, a device object 800 may be disposed at a position moved in a length direction (e.g., y-axis direction) based on the second area 612 of the protective layer 610. The device object 800 may mean a component disposed at one surface of the flexible display 600. For example, the device object 800 may include a drive motor 260 (see FIG. 5A) disposed at one surface of the flexible display 600.

With reference to FIGS. 13A and 13B, while the electronic device 200 (see FIG. 5A) is switched from the slide-out state to the slide-in state, a distance (e.g., a distance in the y-axis direction) between the flexible display 600 and the device object 800 may become closer. While the electronic device 200 (see FIG. 5A) is switched from the slide-out state to the slide-in state, at least a portion of the adhesive layer 620 included in the flexible display 600 may slip in a length direction (e.g., y-axis direction) of the flexible display 600. Because the second area 612 of the protective layer 610 is positioned between a plurality of layers (e.g., layers other than the protective layer 610) included in the flexible display 600 and the device object 800, a portion of the adhesive layer 620 may be prevented from directly contacting the device object 800.

In an embodiment, the second area 612 may be connected to the lattice layer 650 to prevent foreign substances from entering the flexible display 600. For example, the second area 612 may be connected to the lattice layer 650 and be disposed to enclose one end of the flexible display 600 from an outer edge. Because the second area 612 encloses one end of the flexible display 600, external foreign substances are prevented from entering the flexible display 600, and a problem that foreign substances and the adhesive layer 620 adhere may be reduced.

An electronic device according to an embodiment of the disclosure may be various types of devices. The electronic device may include, for example, a portable communication device (e.g., smart phone), a computer device, a portable multimedia device, a portable medical device, a camera, a wearable device, or a home appliance device. The electronic device according to an embodiment of the disclosure is not limited to the above-described devices.

It should be understood that an embodiment of the disclosure and terms used therein are not intended to limit the technical features described in the disclosure to specific embodiments, but include various modifications, equivalents, or substitutions of the embodiments. In connection with the description of the drawings, like reference numerals may be used for similar or related components. The singular form of the noun corresponding to the item may include one or more of the item, unless the relevant context clearly dictates otherwise. In the disclosure, each of phrases such as "A or B", "at least one of A and B", "at least one of A or B", "A, B, or C", "at least one of A, B and C", and "at least one of A, B, or C" may include any one of or all possible combinations of items listed together in the corresponding one of the phrases. Terms such as "first" or "second" may be simply used for distinguishing a corresponding component from other corresponding components, and do not limit the corresponding components in other aspects (e.g., importance or order). In the case that one (e.g., first) component is referred to as "coupled" or "connected" to another (e.g., second) component, with or without the terms "functionally" or "communicatively", it means that the one component may be connected to the other component directly (e.g., by wire), wirelessly, or through a third component.

The term "module" used in an embodiment of the disclosure may include a unit implemented in hardware, software, or firmware, and may be used interchangeably with terms such as, for example, logic, logic block, part, or circuit. The module may be an integrally formed part or a minimum unit or a portion of the part that performs one or more functions. For example, according to an embodiment, the module may be implemented in the form of an application-specific integrated circuit (ASIC).

An embodiment of the disclosure may be implemented into software (e.g., the program 140) including one or more instructions stored in a storage medium (e.g., the internal memory 136 or the external memory 138) readable by a machine (e.g., the electronic device 101). For example, the processor (e.g., the processor 120) of the machine (e.g., the electronic device 101) may call and execute at least one command among one or more stored instructions from a storage medium. This makes it possible for the machine to be operated to perform at least one function according to the called at least one instruction. The one or more instructions may include a code generated by a compiler or a code executable by an interpreter. The machine readable storage medium may be provided in the form of a non-transitory storage medium. Here, 'non-transitory' only means that the storage medium is a tangible device and does not include a signal (e.g., electromagnetic wave), and this term does not distinguish the case that data is semi-permanently stored in the storage medium and the case that data is temporary stored.

According to an embodiment, a method according to an embodiment of the disclosure may be included and provided in a computer program product. Computer program products may be traded between sellers and buyers as commodities. The computer program product may be distributed in the form of a machine readable storage medium (e.g., compact disc read only memory (CD-ROM)), or via an application store (e.g., Play Store™) or may be distributed (e.g., download or upload) online or directly between two user devices (e.g., smartphones). In the case of online distribution, at least a portion of the computer program product may be at least temporarily stored or temporarily generated in a machine readable storage medium such as a memory of a server of a manufacturer, a server of an application store, or a relay server.

According to an embodiment, each component (e.g., module or program) of the above-described components may include a singular entity or a plurality of entities, and some of the plurality of entities may be separately disposed in other components. According to an embodiment, one or more components or operations among the above-described corresponding components may be omitted, or one or more other components or operations may be added. Alternatively or additionally, a plurality of components (e.g., module or program) may be integrated into one component. In this case, the integrated component may perform one or more functions of each component of the plurality of components identically or similarly to those performed by the corresponding component among the plurality of components prior to the integration. According to an embodiment, operations performed by a module, program, or other component may be executed sequentially, in parallel, repeatedly, or heuristically, or one or more of the operations may be executed in a different order, or omitted, or one or more other operations may be added.

**Claims**

1. An electronic device including a flexible display, the electronic device comprising:

   a first housing;
   a second housing slidably coupled to the first housing; and
   a flexible display in which a size of a display area, which is an externally visible part of the electronic device is reduced or expanded based on slide-in or slide-out driving of the second housing,
   wherein the flexible display comprises:

      a panel layer including a display panel;
      a protective layer disposed in one direction of the panel layer and configured to protect the panel layer;
      a lattice layer disposed in another direction of the panel layer;
      a plurality of intermediate layers disposed between the protective layer and the panel layer and including at least one impact absorption layer; and
      a plurality of adhesive layers each disposed between each layer included in the flexible display,
      wherein the protective layer comprises:

         a first area in which the adhesive layers are stacked on one surface; and
         a second area extended from one end of the first area in a direction parallel to the first area and in which a thickness of at least a portion thereof is smaller than that of the first area.

2. The electronic device of claim 1, wherein the second area comprises a coating layer disposed at one surface thereof.

3. The electronic device of claim 1, wherein the second area is formed such that a thickness thereof is smaller than that of the first area throughout the entire second area.

4. The electronic device of claim 1, wherein the second area comprises a concave area in which at least a portion thereof is concave in a height direction thereof.

5. The electronic device of claim 4, wherein the concave area is formed so that a width thereof is longer than a sliding length of one of the plurality of adhesive layers.

6. The electronic device of claim 1, wherein the second area is formed so that a length of a length direction thereof is longer than the sum of sliding lengths of the plurality of adhesive layers.

7. The electronic device of claim 1, wherein the adhesive layer comprises a first adhesive layer, a second adhesive layer, a third adhesive layer, a fourth adhesive layer, a fifth adhesive layer, and a sixth adhesive layer,

the intermediate layer comprises a first intermediate layer, a second intermediate layer, a third intermediate layer, and a fourth intermediate layer, and

in the flexible display, the protective layer, the first adhesive layer, the first intermediate layer, the second adhesive layer, the second intermediate layer, the third adhesive layer, the panel layer, the fourth adhesive layer, the third intermediate layer, the fifth adhesive layer, the fourth intermediate layer, the sixth adhesive layer, and the lattice layer are disposed in a height direction of the flexible display.

8. The electronic device of claim 1, further comprising a bendable member configured to support the flexible display in a bendable manner.

9. The electronic device of claim 8, further comprising a guide rail configured to guide a movement of the bendable member according to sliding of the second housing.

10. The electronic device of claim 1, further comprising a slide cover disposed to be spaced apart from the flexible display.

11. An electronic device including a flexible display, the electronic device comprising:

a first housing;
a second housing slidably coupled to the first housing; and
a flexible display in which a size of a display area, which is an externally visible part of the electronic device is reduced or expanded based on slide-in or slide-out driving of the second housing,
wherein the flexible display comprises:

a panel layer including a display panel;
a protective layer disposed in one direction of the panel layer and configured to protect the display panel;
a lattice layer disposed in another direction of the panel layer;
a plurality of intermediate layers disposed between the protective layer and the lattice layer and including at least one impact absorption layer; and
a plurality of adhesive layers each disposed between each layer included in the flexible display,
wherein the protective layer comprises:

a first area in which the adhesive layers are stacked on one surface; and
a second area extended from one end of the first area, bent and extended toward a height direction of the flexible display in at least a portion, and connected to the lattice layer.

12. The electronic device of claim 11, wherein the lattice layer comprises a connection area formed in a shape protruded from one surface thereof in at least a portion thereof.

13. The electronic device of claim 12, wherein the second area is connected to the connection area of the lattice layer at one end thereof.

14. The electronic device of claim 13, wherein the second area comprises:

a first bending area extended in a length direction of the flexible display and bent and extended in a height direction of the flexible display; and
a second bending area bent in a direction opposite to a bending direction of the first bending area, and
the second area is bent and extended from the first bending area and the second bending area and is connected to the connection area of the lattice layer.

15. The electronic device of claim 11, wherein the adhesive layer comprises a first adhesive layer, a second adhesive layer, a third adhesive layer, a fourth adhesive layer, a fifth adhesive layer, and a sixth adhesive layer, and

the intermediate layer comprises a first intermediate layer, a second intermediate layer, a third intermediate layer, and a fourth intermediate layer,
in the flexible display, the protective layer, the first adhesive layer, the first intermediate layer, the second adhesive layer, the second intermediate layer, the third adhesive layer, the panel layer, the fourth adhesive layer, the third intermediate layer, the fifth adhesive layer, the fourth intermediate layer, the sixth adhesive layer, and the lattice layer are disposed in a height direction of the flexible display.

# FIG. 1

# FIG. 2A

# FIG. 2B

②

219  216  217

200

220

221

222

2213

2211

223

2272

2212  2271  227  A

y

x  z

# FIG. 3A

# FIG. 3B

FIG. 4

EP 4 478 152 A1

FIG. 5A

FIG. 5B

# FIG. 6A

600

650
626
634
625
633
624
640
623
632
622
631
621

612

L1

L2

610    611    613    L3

z

x → y

621
622
623
624
625
626
620

631
632
633
634
630

# FIG. 6B

# FIG. 6C

FIG. 7

# FIG. 8A

# FIG. 8B

# FIG. 9A

600

626
625
624
623
622
621

650
634
633
640
632
631

615

L1
L2

610
611
612

L4

z
x
y

621
622
623
624
625
626

631
632
633
634

620
630

# FIG. 9B

# FIG. 10A

# FIG. 10B

# FIG. 11A

# FIG. 11B

# FIG. 12A

# FIG. 12B

FIG. 13A

FIG. 13B

## INTERNATIONAL SEARCH REPORT

| International application No. |
|---|
| **PCT/KR2023/003706** |

### A. CLASSIFICATION OF SUBJECT MATTER

**G06F 1/16**(2006.01)i; **G09F 9/30**(2006.01)i; **G02F 1/1333**(2006.01)i; **H10K 77/10**(2023.01)i

According to International Patent Classification (IPC) or to both national classification and IPC

### B. FIELDS SEARCHED

Minimum documentation searched (classification system followed by classification symbols)

G06F 1/16(2006.01); B32B 27/08(2006.01); B32B 27/20(2006.01); G02B 5/30(2006.01); G09F 9/30(2006.01); H01L 27/32(2006.01); H01L 51/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 플렉서블(flexible), 디스플레이(display), 하우징(housing), 슬라이딩(sliding), 패널(panel), 보호(protect), 점착(adhesion), 영역(area), 두께(thickness)

### C. DOCUMENTS CONSIDERED TO BE RELEVANT

| Category* | Citation of document, with indication, where appropriate, of the relevant passages | Relevant to claim No. |
|---|---|---|
| A | CN 211980055 U (SHENZHEN ROYOLE DISPLAY TECHNOLOGY CO., LTD.) 20 November 2020 (2020-11-20)<br>See paragraphs [0028]-[0068]; claim 1; and figures 4-12. | 1-15 |
| A | CN 113823195 A (HEFEI VISIONOX TECHNOLOGY CO., LTD.) 21 December 2021 (2021-12-21)<br>See paragraphs [0037]-[0065]; claim 1; and figures 1-8. | 1-15 |
| A | US 2019-0140199 A1 (SHARP KABUSHIKI KAISHA) 09 May 2019 (2019-05-09)<br>See paragraphs [0031]-[0086]; claims 1-5; and figures 1-9. | 1-15 |
| A | KR 10-2020-0069527 A (LG DISPLAY CO., LTD.) 17 June 2020 (2020-06-17)<br>See paragraphs [0059]-[0067]; and figures 3-4. | 1-15 |
| A | KR 10-2020-0033366 A (SAMSUNG DISPLAY CO., LTD.) 30 March 2020 (2020-03-30)<br>See paragraphs [0050]-[0084]; and figures 1-5. | 1-15 |

☐ Further documents are listed in the continuation of Box C.　　☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **27 June 2023** | **27 June 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT
Information on patent family members

International application No.

**PCT/KR2023/003706**

| Patent document cited in search report | | | Publication date (day/month/year) | Patent family member(s) | | | Publication date (day/month/year) |
|---|---|---|---|---|---|---|---|
| CN | 211980055 | U | 20 November 2020 | None | | | |
| CN | 113823195 | A | 21 December 2021 | None | | | |
| US | 2019-0140199 | A1 | 09 May 2019 | CN | 108886846 | A | 23 November 2018 |
| | | | | US | 10411207 | B2 | 10 September 2019 |
| | | | | WO | 2017-164115 | A1 | 28 September 2017 |
| KR | 10-2020-0069527 | A | 17 June 2020 | US | 10910589 | B2 | 02 February 2021 |
| | | | | US | 2020-0185641 | A1 | 11 June 2020 |
| KR | 10-2020-0033366 | A | 30 March 2020 | CN | 110927834 | A | 27 March 2020 |
| | | | | EP | 3633004 | A1 | 08 April 2020 |
| | | | | KR | 10-2022-0151593 | A | 15 November 2022 |
| | | | | KR | 10-2465207 | B1 | 09 November 2022 |
| | | | | US | 10665816 | B2 | 26 May 2020 |
| | | | | US | 2020-0091458 | A1 | 19 March 2020 |
| | | | | US | 2020-0235340 | A1 | 23 July 2020 |
| | | | | US | 2021-0320279 | A1 | 14 October 2021 |

Form PCT/ISA/210 (patent family annex) (July 2022)